# EUROPEAN PATENT APPLICATION

(11) **EP 4 614 670 A1**
(43) Date of publication of application: **10.09.2025**
(21) Application number: 25153852.6
(22) Date of filing: 24.01.2025
(51) Int. Cl.: H01M 10/48, H02J 7/00

(54) **BATTERY MANAGEMENT SYSTEM, BATTERY PACK INCLUDING THE SAME, AND METHOD OF DETECTING CONTACT DEFECT MODULE USING THE SAME**

(30) Priority: 04.03.2024 KR 20240030501
(71) Applicant: SAMSUNG SDI CO., LTD., Yongin-si, Gyeonggi-do 17084 (KR)
(72) Inventor: SIM, Sangbong, 17084 Yongin-Si, Gyeonggi-do (KR)
(74) Representative: Michalski Hüttermann & Partner Patentanwälte mbB

(57) **Abstract**

Provided are a battery management system and a battery pack including the same. The battery management system includes a plurality of slave managers provided to correspond to a plurality of battery modules, and configured to uniformly adjust cell voltages of a plurality of battery cells of respective battery modules, a master manager configured to detect a battery module having a contact defect therein among the battery modules as a defective module using a voltage deviation that is a difference between a maximum value and a minimum value of the cell voltages, and a data transmitter configured to electrically connect the master manager and the slave managers to enable data exchange.

## Description

### FIELD

The present disclosure relates to a battery management system, a battery pack including the same, and a method of detecting a contact defect module using the same, and more particularly, to a battery management system for detecting a contact defect module in a battery pack in which a contact defect occurs, a battery pack including the same, and a method of detecting a contact defect module using the same.

### BACKGROUND

In order to use secondary batteries as a power source for vehicles or industrial devices, a battery pack in which a plurality of battery modules including a plurality of secondary battery cells are connected to each other is widely used.

The overall capacity of a battery pack is affected not only by the capacity of each unit module but also by voltage imbalances between battery cells. For example, even in a case where some of the battery modules in the battery pack have sufficient charging capacity, the entire battery pack may be discharged when other battery modules are discharged.

In general, the voltage imbalance of a battery pack is caused by normal discharge through normal use of the battery module and resistance discharge caused by a contact defect inside the battery module.

Normal discharge is battery discharge that occurs during normal use of the battery pack. While the battery pack is operating, individual battery cells of the battery module have different degrees of degradation due to the unique process characteristics of the battery cell, the usage environment, and variations in the operating conditions applied to the battery cells, thereby resulting in voltage deviations in the individual battery cells and in the battery module including such battery cells.

Therefore, as the use time of the battery pack increases, voltage imbalance may occur between battery modules due to normal discharge, and thus, the performance of individual battery modules may deteriorate.

In contrast, resistance discharge is a battery discharge that does not occur in a battery cell but occurs at a defect point created locally by a contact defect within a battery module.

During the manufacturing process of a battery module, contact defects, such as disconnection, may occur, or contact defects may occur due to external forces such as foreign substances or vibrations that penetrate into the interior of the battery during use of the manufactured battery module, thereby resulting in the frequent occurrence of defect points. Such a defect point may function as a current leakage path, and a contact defective module, which is a battery module with a defect point, has a relatively low charging voltage, thereby causing voltage imbalance.

In this case, the voltage imbalance in individual battery modules due to normal discharge may be detected by a pack battery management system (BMS) and can be easily improved by cell balancing.

However, in the case of voltage imbalance due to resistance discharge, after the battery pack is disassembled into individual battery modules, the contact defect of the battery module is detected using an open circuit voltage-internal resistance (OCV-IR) test device.

In particular, disassembling the battery pack causes the vehicle or industrial machine provided with the battery pack to stop operating and involves removal of the defective module followed by reinstallation, thereby costing a significant amount of time and money.

Accordingly, there is an increasing demand for a new battery management system able to detect a contact defective module without stopping operation or disassembling a battery pack, and for a battery pack provided with the same.

The above information disclosed in this Background section is for en hancement of understanding of the background of the present disclosure, a nd therefore, it may contain information that does not constitute related (or prior) art.

### SUMMARY

Embodiments of the present disclosure provide a battery management system for detecting a contact defective module by using a cell balancer.

Other embodiments of the present disclosure provide a battery pack including the battery management system.

Other embodiments of the present disclosure provide a method of detecting a contact defective module in the battery pack by using the battery management system.

However, the technical problem to be solved by the present disclosure is not limited to the above problem, and other problems not mentioned herein, and aspects and features of the present disclosure that would address such problems, will be clearly understood by those skilled in the art from the description of the present disclosure below.

To solve the above technical problem, a battery management system according to an embodiment of the present disclosure may include a plurality of slave managers corresponding respectively to a plurality of battery modules, and configured to uniformly adjust cell voltages of a plurality of battery cells of the respective battery modules, a master manager configured to detect a battery module having a contact defect therein using a voltage deviation that is a difference between a maximum value and a minimum value of the cell voltages, and a data transmitter configured to electrically connect the master manager and the slave managers to enable data exchange.

According to an embodiment, each of the slave managers may comprise a voltage detector respectively connected to a corresponding battery cell to periodically detect the cell voltages, a voltage regulator configured to comprise a plurality of cell balancers connected to the battery cells, and configured perform the balancing operation, and a module controller configured to obtain the cell voltages from the voltage detector, generate the voltage deviation for a corresponding battery module among the battery modules, and control operation of the battery module in accordance with a control operation transmitted from the master manager.

According to an embodiment, the module controller may comprise a module deviation generator configured to set the voltage deviation periodically generated by the voltage detector as a module deviation for a corresponding battery module among the battery modules, a balance controller configured to perform the balancing operation for a balancing module, i.e., a corresponding battery module among the battery modules, in accordance with a balancing signal transmitted from the master manager by driving the voltage regulator for a first set time, and a detection deviation generator configured to drive the voltage regulator for an estimated defective module, i.e., a corresponding battery module among the battery modules, for a second set time shorter than the first set time in accordance with a defect detection signal transmitted from the master manager and generate the voltage deviation for the estimated defective module as a detection deviation.

According to an embodiment, the module controller may comprise an analog-to-digital signal converter allowing the module deviation, the detection deviation, the balancing signal, and the defect detection signal to be transmitted as digital data by the data transmitter.

According to an embodiment, the data transmitter may comprise a wireless communication means.

According to an embodiment, the first set time may have a range of 1 hour or more, and the second set time may have a range of 20 seconds to 40 seconds.

According to an embodiment, the voltage regulator may divide the battery cells of the estimated defective module into a group of even battery cells and a group of odd battery cells, such that separate halves of the second set time are applied to different groups.

According to an embodiment, the voltage regulator may be configured to be connected at a substantially same time to all of the battery cells of the estimated defective module having a voltage distribution that is smaller than a first reference value set for the balancing operation so as not to require the balancing operation.

According to an embodiment, the cell balancers respectively may comprise a passive balancer comprising a resistor and a discharge switch connected in parallel to a corresponding battery cell among the battery cells, and the voltage regulator is configured to discharge all of the battery cells of the estimated defective module for the second set time.

According to an embodiment, the master manager may comprise a control operation setter configured to store the module deviation transmitted from the module controller, compare the module deviation to a set reference value, and select a control operation for the battery module corresponding to the module deviation, a balancing controller configured to, in a case where the module deviation is a balance deviation greater than the first reference value that is the reference value set for the balancing operation, set the battery module corresponding to the balance deviation as the balancing module and generate the balancing signal to control the balancing operation for the balancing module, and a defect detection controller configured to, in a case where the module deviation is a contact defect deviation smaller than the first reference value and greater than a second reference value that is the reference value for contact defect detection, set the battery module corresponding to the contact defect deviation as the estimated defective module and generate the defect detection signal to control detection deviation generation for the estimated defective module.

According to an embodiment, the defect detection controller may comprise a detection signal generator configured to generate the defect detection signal and transmit the defect detection signal to the module controller in accordance with the control operation, a detection deviation storage configured to call the detection deviation for the estimated defective module from the detection deviation generator and store the detection deviation in accordance with the defect detection signal, and a defect determining part configured to determine the estimated defective module to be a defective module in a case where the detection deviation is greater than a set defect determining criterion.

According to an embodiment, the defect determination criterion may be set to have a range of 40% to 60% of the module deviation for the estimated defective module, so that the estimated defective module is determined to be the defective module in a case where the detection deviation is more than 0.4 times to 0.6 times the module deviation.

According to an embodiment, the first reference value ranges from 50 mV to 80 mV and the second reference value ranges from 30 mV to 40 mV.

A battery pack according to an embodiment of the present disclosure may include a lower case configured to accommodate a plurality of battery modules aligned in a line, a plurality of slave managers provided on top of respective battery modules, and configured to uniformly adjust cell voltages of a plurality of battery cells of the respective battery modules, a cover covering the lower case and positioned on top of the slave managers and the battery modules, a master manager provided on an upper surface of the cover to be connected to the slave managers and configured to detect a battery module having a contact defect therein among the battery modules as a defective module using a voltage deviation that is a difference between a maximum value and a minimum value of the cell voltages, and an upper case configured to cover the master manager and coupled to the lower case.

According to an embodiment, each the battery modules may comprise a flat holder holding bus bars sequentially connecting the battery cells and a signal transmission circuit board fixed to the flat holder, and the slave managers may be disposed on the signal transmission circuit board.

According to an embodiment, each of the slave managers may comprise a voltage detector respectively connected to the battery cells to periodically detect the cell voltages, a voltage regulator configured to comprise a plurality of cell balancers connected to the battery cells, respectively, and configured to perform the balancing operation, and a module controller configured to obtain the cell voltages from the voltage detector, generate the voltage deviation for a corresponding battery module among the battery modules, and control operation of the battery module in accordance with a control operation transmitted from the master manager.

According to an embodiment, the module controller may comprise a module deviation generator configured to set the voltage deviation periodically generated by the voltage detector as a module deviation for a corresponding battery module among the battery modules, a balance controller configured to perform the balancing operation for a balancing module, i.e., a corresponding battery module among the battery modules, in accordance with a balancing signal transmitted from the master manager by driving the voltage regulator for a first set time, and a detection deviation generator configured to drive the voltage regulator for an estimated defective module, i.e., a corresponding battery module among the battery modules, for a second set time shorter than the first set time in accordance with a defect detection signal transmitted from the master manager and generate the voltage deviation for the estimated defective module as a detection deviation.

According to an embodiment, the master manager may comprise a control operation setter configured to store the module deviation transmitted from the module controller, compare the module deviation to a first reference value, and select a control operation for the battery module corresponding to the module deviation, a balancing controller configured to, in a case where the module deviation is a balance deviation greater than the first reference value that is the reference value set for the balancing operation, set the battery module corresponding to the balance deviation as the balancing module and generate the balancing signal to control the balancing operation for the balancing module, and a defect detection controller configured to, in a case where the module deviation is a contact defect deviation smaller than the first reference value and greater than a second reference value that is the reference value for contact defect detection, set the battery module corresponding to the contact defect deviation as the estimated defective module and generate the defect detection signal to control detection deviation generation for the estimated defective module.

According to an embodiment, the defect detection controller may comprise a detection signal generator configured to generate the defect detection signal and transmit the defect detection signal to the module controller in accordance with the control operation, a detection deviation storage configured to call the detection deviation for the estimated defective module from the detection deviation generator and store the detection deviation in accordance with the defect detection signal, and a defect determining part configured to determine the estimated defective module to be a defective module in a case where the detection deviation is greater than a set defect determining criterion.

A method of detecting a contact defective module in a battery pack according to an embodiment of the present disclosure may include the steps of generating a voltage deviation, i.e., a difference between maximum and minimum values of cell voltages for a plurality of battery cells of each of battery modules, as a module deviation for a corresponding battery module among the battery module, comparing the module deviation with a first reference value for a balancing operation for the battery modules and a second reference value for contact defect checking for the battery modules, in a case where the module deviation is a contact defect deviation between the first reference value and the second reference value, setting a battery module corresponding to the contact defect deviation as an estimated defective module, performing an instantaneous discharge by connecting the voltage regulator to all of the battery cells of the estimated defective module, generating the voltage deviation of the instantaneously discharged estimated defective module as a detection deviation, and setting the estimated defective module having a detection deviation greater than a set defect determination criterion as a defective module.

According to embodiments of the disclosure, an estimated defective module may be selected based on a set reference value, and after an instantaneous discharge by the voltage regulator performing cell balancing, a defective module may be detected by comparing a detection deviation, i.e., a voltage deviation, with a module deviation.

Accordingly, a contact defect in the battery modules of the battery pack may be readily detected without disassembling the battery pack.

However, aspects and features of the present disclosure are not limited to those described above, and other aspects and features not mentioned will be clearly understood by a person skilled in the art from the detailed description, described below.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings:
FIG. 1 illustrates the configuration of a battery pack according to embodiments of the present disclosure;
FIG. 2 illustrates an exploded perspective diagram showing a battery module included in the battery pack shown in FIG. 1;
FIG. 3 illustrates a battery management system of the battery pack shown in FIG. 1;
FIG. 4 illustrates a cell balancer provided in the voltage regulator shown in FIG. 3;
FIGS. 5A to 5C illustrate voltage deviations after an instantaneous discharge is applied to a normal module, i.e., a battery module without a contact defect;
FIGS. 6A through 6C illustrate voltage deviations after an instantaneous discharge is applied to a battery module having a contact defect; and
FIG. 7 illustrates a flowchart showing a method of detecting a defective module using the battery control system shown in FIG. 3.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would comply with the requirements of 35 U.S.C. § 112(a) and 35 U.S.C. § 132(a).

References to two compared elements, features, etc. as being "the same" may mean that they are "substantially the same." Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may be disposed in contact with the upper (or lower) surface of the element, and another element may also be interposed between the element and the arbitrary element disposed on (or under) the element.

In addition, it will be understood that when a component is referred to as being "linked," "coupled," or "connected" to another component, the elements may be directly "coupled," "linked" or "connected" to each other, or another component may be "interposed" between the components".

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

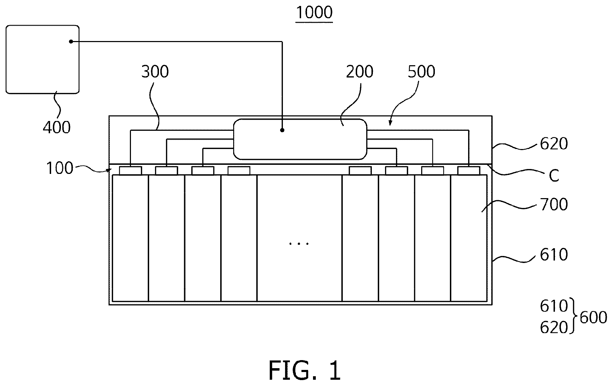

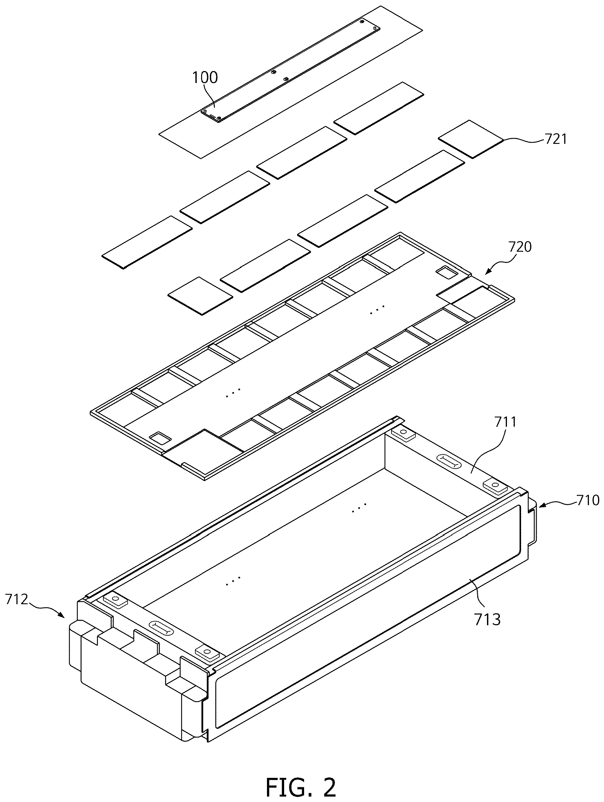

FIG. 1 illustrates the configuration of a battery pack according to embodiments of the present disclosure, and FIG. 2 illustrates an exploded perspective diagram showing a battery module included in the battery pack shown in FIG. 1.

Referring to FIGS. 1 and 2, a battery pack 1000 according to embodiments of the present disclosure may include a plurality of battery modules 700 disposed within a case 600 and a battery control system 500 including a slave manager 100 and a master manager 200.

For example, the case 600 includes a lower case 610 and an upper case 620, in which the lower case 610 and the upper case 620 are combined to provide an enclosed space in which the battery modules 700 and the battery control system 500 are disposed. Therefore, the case 600 may be made of various materials as long as the case may accommodate and reliably protect the battery modules 700 and the battery control system 500 from external impacts and sufficiently dissipate the driving heat of the battery modules 700.

A plurality of battery modules 700 may be provided to be aligned in a line within the lower case 610 provided in the shape of a container.

Each of the battery modules 700 may include a battery frame 710 provided with a plurality of battery cells 711 and a flat holder 720 holding bus bars 721. The slave manager 100 serving as a battery management system (BMS) for a module may be located on the flat holder 720 to individually control the battery cells 711.

FIG. 2 illustrates a configuration of the battery modules 700, and the battery modules 700 shown in FIG. 1 have substantially the same configuration.

In an embodiment, the battery module 700 may include a hexahedral battery frame 710 and the battery cells 711 are aligned and fixed in one direction within the battery frame 710. The battery cells 711 may be aligned in one direction on a bottom plate (not shown) and fixed by an end plate 712 and a side plate 713.

The battery cells 711 may include various unit cells capable of generating electrical energy. In the present disclosure, each of the battery cells 711 may be implemented as a secondary battery in which charging and discharging may be performed reversibly. The battery cells 711 may be electrically connected to each other by the bus bars 721 connecting adjacent positive and negative terminals to each other.

Each of the bus bars 721 may be implemented as a conductive member electrically connecting the adjacent battery cells 711 by combining with each other the positive or negative terminals of the adjacent battery cells 711. For example, the bus bars 721 may be implemented as low-resistance metal plates and may be connected to the positive or negative terminals of adjacent battery cells 711. Accordingly, the battery cells 711 provided in the battery frame 710 may be electrically connected to each other by bus bars 721.

Flat holder 720 is provided as a flat plate covering the top portion of the battery frame 710 to hold the bus bars 721, with the slave manager 100 able to control the operation of the battery modules 700 and a cooling means (not shown) for absorbing the drive heat of the respective battery cells 711 may be disposed on top of the flat holder 720.

The slave manager 100 is disposed on top of each of the battery modules 700 and may perform a balancing operation to uniformly adjust cell voltages of the battery cells 711 of the battery modules 700. The detailed configuration and operation of the slave manager 100 will be described in detail later.

A cover C is disposed to cover the upper portion of the lower case to seal the slave manager 100 from the outside. Accordingly, the battery modules 700 and the slave manager 100 are accommodated in a lower case 610 and covered with the cover C to be separated from the outside. For example, the cover C is made of a resin composition having insulating properties and sufficient strength to electrically separate the slave manager 100 positioned at the bottom from the master manager 200 positioned at the top.

In this embodiment, the cover C is made of plastic and the upper surface is provided as a flat surface to stably support the master manager 200. The master manager 200 is disposed on the upper surface of the cover C to control a plurality of slave managers 100 thereby controlling the battery modules 700 to operate as a single energy source. Accordingly, the master manager 200 and the slave managers 100 may serve as the battery management system 500 designed for a battery pack and able to manage the battery pack 1000. In particular, the master manager 200 is connected to the slave managers 100, and may detect a defective module, i.e., a battery module having an internal contact defect, using voltage deviations, i.e., differences between the maximum and minimum values of the cell voltages. A defective module, i.e., a battery module performing resistance discharge due to a contact defect, may be readily detected from inside without removing the battery modules 700 from the battery pack 1000,

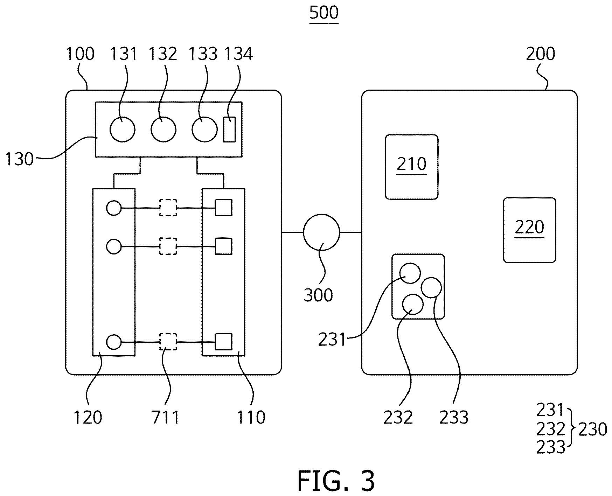

FIG. 3 illustrates a battery management system of the battery pack shown in FIG. 1.

Referring to FIG. 3, the battery management system 500 which is able to control the operation of the battery pack 1000 including a plurality of battery modules 700 according to an embodiment of the present disclosure will be described. For example, the battery management system 500 may include: the slave managers 100 disposed on top of respective battery modules 700, to individually control the operation of corresponding battery modules 700; and the master manager 200 connected to the slave managers 100 through a data transmitter 300 to control the slave managers 100.

The slave managers 100 are provided in a number corresponding to the number of the battery modules 700, and the master manager 200 may be provided as a single manager to control the slave managers 100. A plurality of master managers 200 may be provided depending on the characteristics of the battery pack 1000.

In an embodiment, the slave managers 100 are provided to correspond to the battery modules 700, and may detect the operating characteristics and control the operation of the battery modules 700, respectively, based on the detected operating characteristics. For example, the slave managers 100 may detect cell voltages of the respective battery cells 711 by a voltage detector 110 described later or detect cell temperatures of the respective battery cells 711 by a temperature detector (not shown). The temperatures and voltages of the battery cells 711 of each of the battery modules 700 may be detected and processed to control the battery modules 700 to operate efficiently. Accordingly, voltage and temperature may function as operating characteristic factors by which the operation of the battery modules 700 may be controlled.

In the present embodiment, because the detection of a defective module, i.e., a battery module 700 having an internal contact defect, using the cell voltages is disclosed, the operation control of the battery modules 700 using the cell temperature is not explicitly disclosed, but it should be understood that the respective battery cells 711 or the respective battery modules 700 may be properly cooled using the cell temperature.

For example, each of the slave managers 100 may include the voltage detector 110, a voltage regulator 120, and a module controller 130. The voltage detector 110 may be respectively connected to the positive and negative terminals of the battery cells 711 to detect cell voltages, i.e., voltages applied to the opposite ends of the battery cells 711. Accordingly, the voltage detector 110 may be provided in a number corresponding to the number of the battery cells 711. In particular, the voltage detector 110 is configured to repeatedly detect the cell voltages of the battery cells 711 at a predetermined cycle while the battery pack 1000 is operating. As the operating time of the battery pack 1000 increases, the degrees of degradation of the battery cells 711 differ depending on the characteristics of respective manufacturing processes or the operating conditions. Accordingly, the respective battery cells 711 may have deviations in the cell voltages, and voltage deviations also may occur in each battery module 700 including the battery cells 711.

Accordingly, during operation of the battery pack 1000, the voltage detector 110 periodically detects cell voltages to observe the voltage distribution among the battery cells 711. In the present embodiment, the cell voltage distribution of the battery module 700 is evaluated by voltage deviations, i.e., differences between the maximum voltage and the minimum voltage. However, this is for illustrative purposes, and the cell voltage distribution may be expressed in terms of various physical quantities in a case where the actual voltage distribution of the battery module 700 may be accurately described.

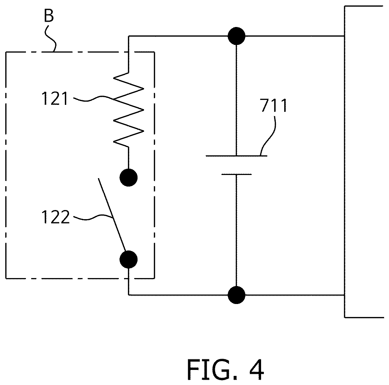

The voltage detector 110 may transmit to the module controller 130the cell voltages of the corresponding battery module 700, and the voltage deviations may be obtained by the module controller 130. For example, the voltage regulator 120 may be individually connected to a plurality of battery cells 711 to perform the balancing operation to form a uniform distribution of cell voltages. Accordingly, in a case where a particular battery module 700 has a voltage deviation exceeding an acceptable value, the balancing operation is performed by the voltage regulator 120. In the present embodiment, the voltage regulator 120 may include cell balancers B (see FIG. 4) connected in parallel to the respective battery cells 711.

FIG. 4 illustrates a cell balancer provided in the voltage regulator shown in FIG. 3.

Referring to FIG. 4, the voltage regulator 120 includes a plurality of cell balancers B connected in parallel to the respective battery cells 711. Accordingly, like the voltage detector 110, the voltage regulator 120 may be provided in a number corresponding to the number of the battery cells 711.

For example, each of the cell balancers B may be provided as a passive balancer including a discharge resistor 121 and a discharge switch 122 and connected in parallel to a battery cell 711. When a balancing signal for the battery module 700 is applied, the discharge switch 122 is connected and the battery cell 711 is discharged by the discharge resistor 121 to lower the cell voltage of the battery cell 711. Accordingly, a battery cell 711 having a relatively high voltage may be discharged to reduce the voltage deviation between the battery cells 711 of the battery module 700.

For example, the module controller 130 may obtain a cell voltage from the voltage regulator 120, generate a voltage deviation for each battery module 700, and control the operation of the battery module 700 in accordance with a control action transmitted from the master manager 200. The module controller 130 may control the operation of the corresponding battery module 700 in accordance with the control operation signal transmitted from the master manager 200. For example, a balancing operation or a cooling operation for the battery module 700 may be controlled.

For example, the module controller 130 may include a module deviation generator 131, a balance controller 132, and a detection deviation generator 133. The module deviation generator 131 may set a voltage deviation periodically generated by the voltage detector 110 as a module deviation for the corresponding battery module 700. A plurality of cell voltages transmitted from the voltage detector 110 are compared with each other to detect a maximum cell voltage and a minimum cell voltage, and a voltage deviation is obtained based on differences therebetween. The voltage deviation may be obtained for each battery module 700 and set as a module deviation for the battery module 700.

Accordingly, the module deviation generator 131 may generate a module deviation that is a voltage deviation differentiated for each battery module 700.

The balance controller 132 may perform a balancing operation for the balancing module, i.e., the corresponding battery module 700, by driving the voltage regulator 120 for a first predetermined time in accordance with the balancing signal transmitted from the master manager 200.

As will be described later, the balancing signal is generated when a balance deviation, i.e., a module deviation greater than a predetermined comparison value, is detected, and the balancing operation is performed on the balancing module, i.e., is the battery module 700 corresponding to the balance deviation. Thus, in a case where the balancing signal from the master manager 200 is applied to the module controller 130, the balance controller 132 performs the balancing operation on the balancing module.

The detection deviation generator 133 may drive the voltage regulator 120 for a second predetermined time shorter than the first predetermined time for an estimated defective module, i.e., a corresponding battery module 700, according to a defect detection signal transmitted from the master manager 200, and generate a voltage deviation for the estimated defective module as a detection deviation. The detection deviation generator 133 may perform an instantaneous discharge using the voltage regulator 120 for the estimated defective module in accordance with the defect detection signal, and then detect and obtain the voltage deviation as the detection deviation.

A signal converter 134 may convert the module deviation, the detection deviation, the balancing signal, and the defect detection signal into digital signals. Accordingly, data transmission between the slave manager 100 and the master manager 200 may be performed using digital signals. For example, the signal converter 134 may be implemented as an analog-to-digital converter. In particular, the data transmitter 300 may be implemented as a wireless communication means by transmitting data on digital signals between the slave manager 100 and the master manager 200.

The balancing operation for the battery module 700 is performed over a relatively long period of time, but the discharging operation for detecting a defective module is performed instantaneously.

As will be described later, the discharging operation for detecting a defective module is performed for a battery module 700 that does not have a voltage deviation large enough to perform a balancing operation. Accordingly, in a case where the module deviation is large enough to perform the balancing operation, the balancing operation is performed first to reduce the voltage deviation before the contact defect detecting operation is performed. Thus, the discharge operation is performed for a short period of time so as not to adversely affect the stabilized voltage deviation for a battery module 700 that does not require the balancing operation.

For example, a first set time may be set to have a range of more than one hour or from several hours to tens of hours, and the second set time may be set to have a range of about 20 seconds to about 40 seconds. In particular, in a case where the instantaneous discharge is performed by the voltage regulator 120 for the estimated defective module, it is desirable to group the battery cells 711 and then perform the instantaneous discharge sequentially for the respective groups, rather than simultaneously for all of the battery cells 711, as the uniformity of the instantaneous discharge may thereby be increased. For example, the battery cells 711 of the estimated defective module may be divided into a group of even battery cells and a group of odd battery cells and then the halves of the second set time may be sequentially applied to the respective groups.

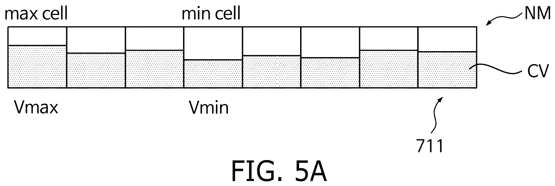

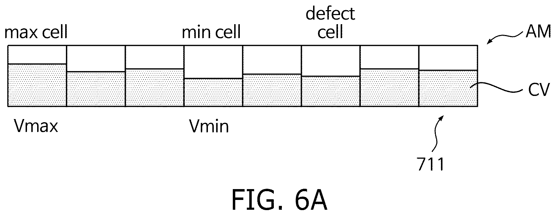

FIGS. 5A to 5C and FIGS. 6A to 6C are diagrams illustrating whether an estimated defective module has a contact defect using an instantaneous discharge by the voltage regulator.

FIGS. 5A to 5C illustrate voltage deviations after an instantaneous discharge is applied to a normal module, i.e., a battery module without a contact defect.

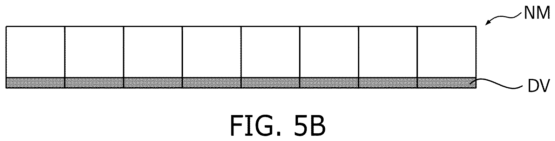

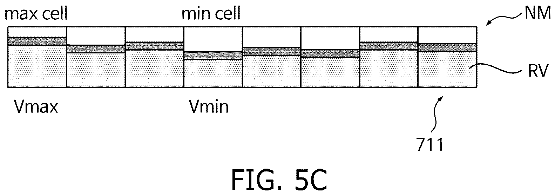

FIG. 5A illustrates voltages at respective battery cells 711 in a normal module, and FIG. 5B illustrates voltages of the respective battery cells 711 due to an instantaneous discharge applied to the normal module. FIG. 5C illustrates a diagram obtained by superimposing FIGS. 5A and 5B.

The battery module in FIG. 5A is a normal module NM without a contact defect, and cell voltages of the respective battery cells 711 have slight deviations. In FIG. 5A, the size of a hatching filling each battery cell 711 is indicative of a cell voltage. Thus, the voltage deviations of the normal module NM may be set as the difference between the maximum cell voltage Vmax and the minimum cell voltage Vmin.

Referring to FIG. 5B, the voltage regulator 120 performs an instantaneous discharge by momentarily contacting all of the battery cells 711 of the normal module NM. By connecting the discharge switch for a short period of time, such as the second set time, equal electrical energy is discharged from all of the battery cells 711. In particular, the potential deviations of the normal module NM may still remain stabilized with the instantaneous discharge.

FIG. 5C is a superimposition of FIGS. 5A and 5B, illustrating a state in which the discharge voltage of FIG. 5B has been removed from the cell voltages of FIG. 5A, and residual voltages RV are applied to the respective battery cells 711.

Because the uniform discharge voltage DV is removed from the cell voltages CV of FIG. 5A, the voltage distribution of the cell voltages CV becomes the same as the voltage distribution of the residual voltages RV. Accordingly, even in a case where an instantaneous discharge is applied to the normal module NM, the voltage deviations remain the same. However, as shown in FIGS. 6A to 6C, in a case where a contact defect occurs inside the battery module, current deviations change due to the resistive discharge at the defect point.

FIGS. 6A through 6C illustrate voltage deviations after an instantaneous discharge is applied to a battery module having a contact defect.

The battery module in FIG. 6A is a defective module AM with contact defects, and cell voltages CV of the respective battery cells 711 have slight deviations. In FIG. 6A, the size of a hatching filling each respective battery cell 711 is indicative of a cell voltage. Therefore, the voltage deviations of the defective module AM may be set as the difference between the maximum cell voltage Vmax and the minimum cell voltage Vmin.

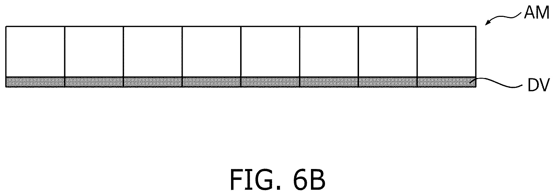

Referring to FIG. 6B, the voltage regulator 120 performs an instantaneous discharge by momentarily contacting all of the battery cells 711 of the defective module AM. By connecting the discharge switch for a short period of time, such as a second set time, equal electrical energy is discharged from all of the battery cells 711. In particular, as in FIG. 5B, the potential deviations of the defective module AM may still remain stabilized with the instantaneous discharge.

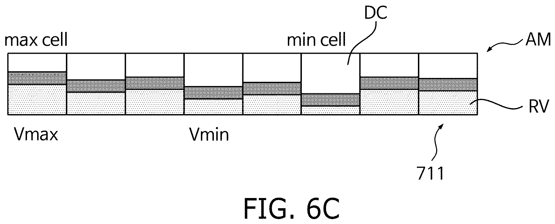

FIG. 6C is a superimposition of FIGS. 6A and 6B, illustrating a state in which the discharge voltage DV of FIG. 6B has been removed from the cell voltages of FIG. 6A, and residual voltages RV are applied to the respective battery cells 711.

The uniform discharge voltage DV should be removed from the cell voltages CV in FIG. 6A, but a defective cell DC in which the contact defect has occurred may have a greater amount of discharge due to excessive resistive discharge compared with that of the battery cell 711 without a contact defect. Accordingly, in the defective module AM, the maximum cell voltage Vmax is the same but one of the residual voltages RV of the defective cell DC becomes a new minimum cell voltage Vmin, and the voltage deviations of FIG. 6C are increased to be significantly greater than the voltage deviations of FIG. 6A. In a case where an instantaneous discharge is performed by the voltage regulator 120 for a module whose voltage deviations remain stable, a normal cell has residual voltages reduced by the discharge voltage but a defective cell having a contact defect has residual voltages RV further reduced by the resistive discharge caused by the contact defect, thereby resulting in an increase in current deviations. Accordingly, in a case where the difference between the voltage deviations before and after the instantaneous discharge by the voltage regulator 120 is equal to or greater than a reference value, it may be interpreted as the presence of a defective cell causing a contact defect.

Because it is desirable to determine the contact defect based on the degree of discharge of the battery cells 711, the voltage regulator 120 is implemented as a passive balancer.

In an embodiment, the master manager 200 may include a control operation setter 210, a balancing controller 220, and a defect detection controller 230.

The control operation setter 210 may store a module deviation transmitted from the module controller 130 and may select a control operation for the battery module corresponding to the module deviation by comparing the module deviation with a set reference value. In response to the periodic operation of the voltage detector 110, the module deviations of the respective battery modules 700 are periodically transmitted to the control operation setter 210. The control operation setter 210 compares the module deviations with the pre-stored reference value to detect a battery module requiring the operation control and performs the required control operation.

In the present embodiment, the control operation of the master manager 200 for the battery modules 700 may include a balancing operation and a contact defect detection operation. The reference value may include a first reference value for performing the balancing operation and a second reference value for performing the contact defect detection. In the present embodiment, the first reference value may range from 50 mV to 80 mV and the second reference value may range from 30 mV to 40 mV. For example, in a case where the first reference value is 80 mV and the second reference value is set to 40 mV, the balancing operation is performed for battery modules 700 having a transmitted module deviation of 80 mV or more, and the contact defect detecting operation is performed for battery modules 700 having a transmitted module deviation of 50 mV.

Therefore, in a case where the module deviation is a balance deviation greater than the first reference value, i.e., a reference value set for the balancing operation, the balancing controller 220 sets the battery module 700 corresponding to the balance deviation as a balancing module and generates a balancing signal to control the balancing operation for the balancing module.

In addition, in a case where the module deviation is a contact defect deviation smaller than the first reference value and greater than the second reference value, i.e., a contact defect detection reference value, the defect detection controller 230 may set a battery module 700 corresponding to the contact defect deviation as an estimated defective module and generate a defect detection signal to control a detection deviation generating operation for the estimated defective module. For example, the defect detection controller 230 may include a detection signal generator 231 generating a defect detection signal and transmitting to the module controller 130 the defect detection signal in accordance with a control operation, a detection deviation storage 232 calling a detection deviation for the estimated defective module from the detection deviation generator and storing the detection deviation in accordance with the defect detection signal, and a defect determining part 233 determining the estimated defective module to be a defective module in a case where the detection deviation is greater than a set defect determination criterion.

In a case where a module deviation between the first reference value and the second reference value is detected, the module deviation is set as a contact defect deviation, and a battery module 700 corresponding to the contact defect deviation is set as the estimated defective module. At the same time, a defect detection signal is generated and transmitted to the module controller 130. The module controller 130 may obtain a detection deviation for the estimated defective module by driving the detection deviation generator 133 in accordance with the defect detection signal.

As described above, all of the battery cells 711 of the estimated defective module are instantaneously discharged for the second set time by the voltage regulator 120. After the instantaneous discharge, the cell voltages of the respective battery cells 711 of the estimated defective module are detected by the voltage detector 110, and the differences between the maximum cell voltage and the minimum cell voltage are obtained as the detection deviations. The detection deviation is stored in the detection deviation storage 232.

The defect determining part 233 may compare the transmitted module deviation with a set defect determination criterion to determine whether the corresponding module is defective. In a case where the module deviation of the estimated defective module meets the defect determination criterion, the estimated defective module is determined to be a defective module, and in a case where the module deviation does not meet the defect determination criterion, the estimated defective module is determined to be a normal module. For example, the defect determination criterion may be set to have a range of 40% to 60% of the module deviation of the estimated defective module. In this case, the estimated defective module is determined to be the defective module in a case where the detection deviation is more than 0.4 times to 0.6 times the module deviation.

In a case where a defective module is detected, the battery pack 1000 may be disassembled into battery modules and the defective module may be replaced with a new module.

According to the battery pack including the battery control system as described above, a defective module may be detected by selecting an estimated defective module according to a set reference value and comparing a detection deviation, i.e., a voltage deviation after an instantaneous discharge by the voltage regulator 120 performing cell balancing, and a module deviation. Accordingly, a contact defect in the battery modules of the battery pack may be easily detected without disassembling the battery pack.

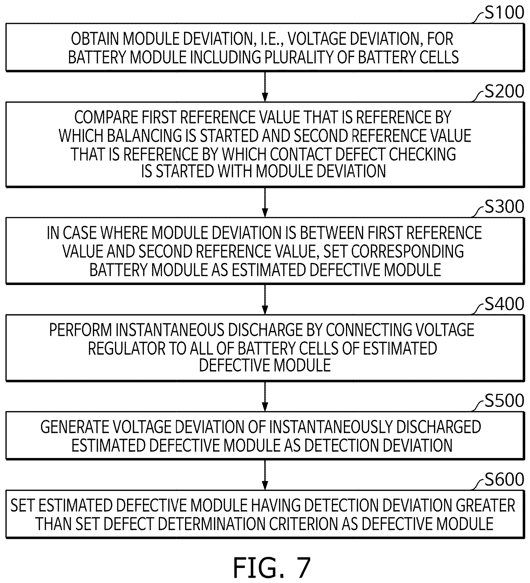

FIG. 7 illustrates a flowchart showing a method of detecting a defective module using the battery control system shown in FIG. 3.

Referring to FIG. 7, first, voltage deviations, i.e., differences between maximum and minimum values of cell voltages for a plurality of battery cells 711 of each battery module 700, are generated as a module deviation for the battery module 700 in step S100.

The battery pack 1000 includes a plurality of battery modules 700, and during operation of the battery pack 1000, the voltage detector 110 periodically detects the cell voltages for each of the battery modules 700, and the module controller 130 obtains voltage deviations for each of the battery modules 700 and sets the same as a module deviation. The module deviation is transmitted to the master manager 200 and compared with a reference value.

Thereafter, the master manager 200 compares the module deviation with a first reference value for a balancing operation for the battery modules 700 and a second reference value for contact defect checking for the battery modules 700 in step S200 and determines a control operation for the battery modules. At this time, the first reference value and the second reference value may be input via the interface 400 connected to the master manager 200.

In a case where the module deviation is a contact defect deviation between the first reference value and the second reference value, a battery module corresponding to the contact defect deviation is set as an estimated defective module in step S300, and an instantaneous discharge is performed by connecting the voltage regulator to all of the battery cells of the estimated defective module in step S400.

Because the voltage deviation of the estimated defective module is lower than the first reference value, the respective battery cells 711 remain stable, and thus, in a case where an instantaneous discharge is applied to the estimated defective module, the respective battery cells 711 are discharged equally.

The voltage deviation of the instantaneously discharged estimated defective module is generated as a detection deviation in step S500, and then the estimated defective module having a detection deviation greater than a set defect determination criterion is set as a defective module in step S600.

In a case with no contact defect, all of the battery cells 711 will be discharged uniformly and there will be no difference in voltage deviations before and after the instantaneous discharge, but in a case with a contact defect, the discharge voltage will be increased due to a resistance discharge in a defective cell having the contact defect.

Accordingly, in a case where the increase in the detection deviation exceeds 40% to 60% of the module deviation, the estimated defective module is detected as a defective module.

According to the battery management system, the battery pack including the same, and the method of detecting the contact defect module a high resistance defect using the same as described above, an estimated defective module may be selected based on a set reference value, and after an instantaneous discharge by the voltage regulator performing cell balancing, a defective module may be detected by comparing a detection deviation, i.e., a voltage deviation, with a module deviation.

Accordingly, a contact defect in the battery modules of the battery pack may be easily detected without disassembling the battery pack.

Although the present disclosure has been described above with respect to embodiments thereof, the present disclosure is not limited thereto. Various modifications and variations can be made thereto by those skilled in the art within the spirit of the present disclosure and the equivalent scope of the appended claims.

What is claimed is:

## Claims

1. A battery management system (500) comprising:
a plurality of slave managers (100) for a plurality of battery modules (700), wherein each slave manger (100) is configured to perform a balancing operation, that includes uniformly adjusting cell voltages CV of a plurality of battery cells (711) of a respective battery module (700);
a master manager (200) configured to detect a battery module (700) among the battery modules (700) having a contact defect therein as a defective module using a voltage deviation being a difference between a maximum value Vmax and a minimum value Vmin of the cell voltages CV; and
a data transmitter (300) configured to electrically connect the master manager (200) and the slave managers (100) to enable data exchange.

2. The battery management system (500) as claimed in claim 1, wherein each of the slave managers (100) comprises:
a voltage detector (110) connected to a respective battery cell (711) to periodically detect the cell voltages CV;
a voltage regulator (120) configured to comprise a plurality of cell balancers B connected to the battery cells (711), and configured to perform the balancing operation; and
a module controller (130) configured to obtain the cell voltages CV from the voltage detector (110), generate the voltage deviation for a corresponding battery module (700) among the battery modules (700), and control operation of the battery module (700) in accordance with a control operation transmitted from the master manager (200).

3. The battery management system (500) as claimed in claim 2, wherein the module controller (130) comprises:
a module deviation generator (131) configured to set the voltage deviation periodically generated by the voltage detector (110) as a module deviation for a corresponding battery module (700) among the battery modules (700);
a balance controller (132) configured to perform the balancing operation for a balancing module, being a corresponding battery module (700) among the battery modules (700), in accordance with a balancing signal transmitted from the master manager (200) by driving the voltage regulator (120) for a first set time; and
a detection deviation generator (133) configured to drive the voltage regulator (120) for an estimated defective module, being a corresponding battery module (700) among the battery modules (700), for a second set time shorter than the first set time in accordance with a defect detection signal transmitted from the master manager (200) and generate the voltage deviation for the estimated defective module as a detection deviation.

4. The battery management system (500) according to any of the claims 2 or 3, wherein the module controller (130) comprises an analog-to-digital signal converter (134) allowing the module deviation, the detection deviation, the balancing signal, and the defect detection signal to be transmitted as digital data by the data transmitter (300).

5. The battery management system (500) according to any of the previous claims, wherein the data transmitter (300) comprises a wireless communication means.

6. The battery management system (500) as claimed in claim 3, wherein the first set time has a range of 1 hour or more, and the second set time has a range of 20 seconds to 40 seconds.

7. The battery management system (500) according to claim 3 or 6 , wherein the voltage regulator (120) divides the battery cells (711) of the estimated defective module into a group of even battery cells and a group of odd battery cells, such that separate halves of the second set time are applied to different groups.

8. The battery management system (500) according to any of the claims 3, 6, or 7, wherein the voltage regulator (120) is configured to be connected at substantially the same time to all of the battery cells (711) of the estimated defective module having a voltage distribution that is smaller than a first reference value set for the balancing operation.

9. The battery management system (500) according to any of the claims 3, 6, 7, or 8, wherein the cell balancers B may be provided as a passive balancer comprising a resistor (121) and a discharge switch (122) connected in parallel to a corresponding battery cell (711) among the battery cells (711), and the voltage regulator (120) is configured to discharge all of the battery cells (711) of the estimated defective module for the second set time.

10. The battery management system (500) according to any of the previous claims, wherein the master manager (200) comprises:
a control operation setter (210) configured to store the module deviation transmitted form the module controller (130), compare a set reference value, and select a control operation for the battery module (700) corresponding to the module deviation;
a balancing controller (220) configured to, in a case where the module deviation is a balance deviation greater than a first reference value that is the reference value set for the balancing operation, set the battery module (700) corresponding to the balance deviation as the balancing module and generate the balancing signal to control the balancing operation for the balancing module; and
a defect detection controller (230) configured to, in a case where the module deviation is a contact defect deviation smaller than the first reference value and greater than a second reference value that is the reference value for contact defect detection, set the battery module (700) corresponding to the contact defect deviation as the estimated defective module and generate the defect detection signal to control detection deviation generation for the estimated defective module.

11. The battery management system (500) as claimed in claim 10, wherein the defect detection controller (230) comprises:
a detection signal generator (231) configured to generate the defect detection signal and transmit the defect detection signal to the module controller 130 in accordance with the control operation;
a detection deviation storage (232) configured to call the detection deviation for the estimated defective module from the detection deviation generator (133) and store the detection deviation in accordance with the defect detection signal; and
a defect determining part (233) configured to determine the estimated defective module to be a defective module in a case where the detection deviation is greater than a set defect determining criterion.

12. The battery management system (500) as claimed in claim 11, wherein the defect determination criterion is set to have a range of 40% to 60% of the module deviation for the estimated defective module, so that the estimated defective module is determined to be the defective module in a case where the detection deviation is more than 0.4 times to 0.6 times the module deviation.

13. The battery management system (500) according to any of the previous claims 10 to 12, wherein the first reference value ranges from 50 mV to 80 mV.

14. The battery management system (500) according to any of the previous claims 10 to 13, wherein the second reference value ranges from 30 mV to 40 mV

15. A method of detecting a contact defect module in a battery pack, preferably performed by a battery management system (500) according to any of the previous claims, the method comprising:
generating a voltage deviation, being a difference between maximum and minimum values of cell voltages for a plurality of battery cells of each of battery modules, as a module deviation for a corresponding battery module among the battery module;
comparing the module deviation with a first reference value for a balancing operation for the battery modules and a second reference value for contact defect checking for the battery modules;
in a case where the module deviation is a contact defect deviation between the first reference value and the second reference value, setting a battery module corresponding to the contact defect deviation as an estimated defective module;
performing an instantaneous discharge by connecting the voltage regulator to all of the battery cells of the estimated defective module;
generating the voltage deviation of the instantaneously discharged estimated defective module as a detection deviation; and
setting the estimated defective module having a detection deviation greater than a set defect determination criterion as a defective module.
